(19) **Europäisches Patentamt / European Patent Office / Office européen des brevets**

(11) **EP 2 309 647 B1**

(12) **EUROPÄISCHE PATENTSCHRIFT**

(45) Veröffentlichungstag und Bekanntmachung des Hinweises auf die Patenterteilung:
**22.08.2018 Patentblatt 2018/34**

(21) Anmeldenummer: **10186362.9**

(22) Anmeldetag: **04.10.2010**

(51) Int Cl.:
**H03K 17/955** (2006.01)          **H03K 17/96** (2006.01)
**G06F 3/033** (2013.01)          F24C 7/08 (2006.01)

(54) **Bedieneinrichtung für ein Elektrogerät**

Operating device for an electric device

Dispositif de commande d'un appareil électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.10.2009 DE 102009049559**

(43) Veröffentlichungstag der Anmeldung:
**13.04.2011 Patentblatt 2011/15**

(73) Patentinhaber: **E.G.O. Elektro-Gerätebau GmbH 75038 Oberderdingen (DE)**

(72) Erfinder:
- **Kraus, Randolf
  75015 Bretten (DE)**
- **Kleinhans, Andreas
  75031 Eppingen (DE)**

(74) Vertreter: **Patentanwälte
Ruff, Wilhelm, Beier, Dauster & Partner mbB
Kronenstraße 30
70174 Stuttgart (DE)**

(56) Entgegenhaltungen:
**EP-A2- 1 416 636          US-A- 4 264 903
US-A1- 2007 262 962**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

**Anwendungsgebiet und Stand der Technik**

Die Erfindung betrifft eine Bedieneinrichtung für ein Elektrogerät, wobei die Bedieneinrichtung ein Bedien-Feld aufweist mit kapazitiven Sensorelementen, um einen kapazitiven Berührungs- bzw. Näherungsschalter zu bilden.

Aus der DE 102 008 033 369 A ist eine Bedieneinrichtung bekannt, die mit Piezo-Sensorelementen arbeitet, also mit der Erfassung einer Durchbiegung, wenn ein Finger auf ein Bedien-Feld über den Sensorelementen gelegt wird.

Des Weiteren ist aus der WO 2007/036247 bekannt, wie eine längliche Bedieneinrichtung als sogenannter Slider ausgebildet ist, bei eine Bedienung durch Auflegen eines Fingers und Ziehen in einer Art Linie über den Slider erfolgt. Damit ist vor allem ein Einstellen beispielsweise einer Leistung in mehreren Stufen bzw. in einem bestimmten Bereich sehr gut möglich.

Aus der US 2007/0262962 A1 ist eine Bedieneinrichtung mit Sensorelementen bekannt, die kapazitiv arbeiten. Dabei sind jeweils viele quadratisch ausgebildete Sensorelemente in Zeilen und Spalten nahe beieinander angeordnet und bilden so ein Feld. Jeweils entlang einer Zeile und jeweils entlang einer Spalte sind die Sensorelemente miteinander verbunden und elektrisch gekoppelt. Jeweils eine solche Reihe von Sensorelementen ist mit einer Steuerung zur Auswertung verbunden.

Aus der EP 1416636 A2 ist eine Bedieneinrichtung für ein Elektrogerät bekannt, welche ebenfalls eine Vielzahl von Sensorelementen entlang einer Reihe bzw. Linie aufweist. Die einzelnen Sensorelemente werden von Abschnitten aus elektrisch leitfähigem Kunststoff gebildet, der in elektrisch isolierenden Kunststoff eingebettet ist.

**Aufgabe und Lösung**

Der Erfindung liegt die Aufgabe zugrunde, eine eingangs genannte Bedieneinrichtung zu schaffen, mit der Probleme des Standes der Technik vermieden werden können und eine Möglichkeit geschaffen wird, eine solche Bedieneinrichtung einfach aufzubauen und mit zuverlässiger Funktion zu versehen.

Gelöst wird diese Aufgabe durch eine Bedieneinrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Es ist vorgesehen, dass die voneinander getrennten kapazitiven Sensorelemente in einer fortlaufenden Reihe bzw. Linie als Gerade angeordnet sind und so eine längliche Bedieneinrichtung bilden für eine vorbeschriebene Bedienung, indem ein Finger darauf, insbesondere auf das Bedien-Feld, gelegt und darübergezogen wird. Vorteilhaft sind die Sensorelemente dabei in gleichem Abstand zueinander angeordnet. Des Weiteren sind die Sensorelemente sämtlich gleich bzw. identisch ausgebildet, und weisen dabei vorteilhaft eine rechteckige Form auf mit zwei gegenüberliegenden ersten Seiten und zwei gegenüberliegenden zweiten Seiten. Erfindungsgemäß sind die Sensorelemente so angeordnet, dass sie mit jeweils einer ihrer ersten Seiten zueinander hin weisen. Somit sind die zueinander hin weisenden Seiten und damit auch die anderen jeweils parallel bzw. die Sensorelemente sind bezüglich der fortlaufenden Linie als Gerade gleich ausgerichtet bzw. in gleichem Winkel verdreht. Die genannten ersten Seiten sind nämlich zu der Linie bzw. in der Richtung ihrer Erstreckung um einen Winkel zwischen 15° und 90° verdreht. In einer vorteilhaften Ausgestaltung kann der Winkel zwischen 45° und 80° liegen, besonders vorteilhaft zwischen 46° und 75°. Er sollte eben etwas mehr als 45° betragen, vor allem dann, wenn die Sensorelemente rechteckig sind und nicht stark von einer quadratischen Form abweichen. In diesem Fall kann der Winkel alternativ auch weniger als 45° betragen, beispielsweise zwischen 15° und 44° liegen.

Durch diese zueinander verdreht bzw. versetzt ausgebildete Anordnung der Sensorelemente ist es möglich, dass sie sich nahezu oder sogar ein Stück überlappen. Dadurch wird eine bessere Linearität und Genauigkeit der Ermittlung der Position eines aufgesetzten Fingers möglich. Insbesondere ergibt sich bei den üblichen Auswerteverfahren für kapazitive Sensorelemente in Berührungsschaltern, beispielsweise entsprechend der EP 859 467 A oder der EP 859 468 A, ein größerer Signalhub, wenn ein Finger entlang der Reihe der Sensorelemente gerade in der Mitte zwischen zwei Sensorelementen ist. Des Weiteren ist bei kapazitiven Sensorelementen zu beachten, dass diese nicht ganz nah beieinander angeordnet sein sollten bzw. noch einen gewissen Abstand zueinander aufweisen sollten, damit eben durch das Abfallen des Signalhubs, wenn ein Finger von einem Mittelpunkt des Sensorelements ausgehend sich dem Zwischenraum zwischen den Sensorelementen nähert, dies auch ausreichend genau unterschieden werden kann. Die Sensorelemente dürfen sich auch keinesfalls berühren. Ein Abstand kann in der Größenordnung geringer als die kleinste Erstreckung eines Sensorelements liegen, in der Regel also etwas geringer sein als die Breite bzw. kurze Seite eines länglichen Sensorelements.

In weiterer vorteilhafter Ausgestaltung der Erfindung sind die Sensorelemente nicht nur rechteckig, sondern weisen eine lange Seite und eine kurze Seite auf, insbesondere mit mindestens 10% Längenunterschied. Ihre Schrägstellung bzw. eine mögliche Überlappung ist besonders dann vorteilhaft möglich, wenn sie mit ihren langen Seiten zueinander hin weisen, also quer zu der Längserstreckung der Linie als Gerade stehen. Die Dimensionierung der Sensorelemente kann dabei so sein, dass sie maximal doppelt so lang wie breit sind.

Die Linie, entlang derer die Sensorelemente angeordnet sind, ist eine Gerade. In diesem Fall sind, wie vorbeschrieben, sämtliche Sensorelemente gleich ausgerichtet.

Es ist möglich, dass sich benachbarte Sensorelemente sogar überlappen. Dies kann derart sein, dass sie sich in einer Richtungskomponente entlang der Längserstreckung der Linie als Gerade ein solches Stück überlappen. Die Überlappung sollte relativ gering sein, beispielsweise mindestens 5% bis 20% der Länge eines Sensorelements betragen. Diese Überlappung steht auch im Zusammenhang mit der Schrägstellung der Sensorelemente relativ zu der Längserstreckung der Linie als Gerade. Als vorteilhaft hat es sich dabei eben herausgestellt, die Sensorelemente nicht zu langgestreckt auszubilden, beispielsweise etwa doppelt lang wie breit, und den Winkel der Schrägstellung sowie den Abstand zueinander so auszugestalten, dass sich eben eine genannte geringe Überlappung ergibt.

Erfindungsgemäß werden Sensorelementkörper verwendet, die aus elektrisch leitfähigem und elastischem Material bestehen, insbesondere einem Kunststoff wie er aus der vorgenannten EP 859 467 A bekannt ist. Die Sensorelementkörper sind dann vorteilhaft in Blockform ausgebildet und werden mit ihrer Oberseite an die Unterseite des Bedienfeldes angelegt. Sie selbst können auf einer Leiterplatte angeordnet sein und elektrisch kontaktiert sein. Die Höhe eines solchen Sensorelementkörpers sollte vorteilhaft geringer sein als seine Länge und Breite, beispielsweise ein Viertel bis ein Drittel der Breite betragen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

## Kurzbeschreibung der Zeichnungen

Ausführungsbeispiele der Erfindung sind in den Zeichnungen schematisch dargestellt und werden im folgenden näher erläutert. In den Zeichnungen zeigen:

Fig. 1          eine Draufsicht auf eine erfindungsgemäße Bedieneinrichtung mit einer Leiterplatte, auf der Sensorelemente in einer Linie angeordnet sind,

Fig. 2 und 3    Vergrößerungen zweier schematischer Darstellungen zweier unterschiedlich schräg versetzt zueinander ange-ordneter Sensorelemente ähnlich Fig. 1 und

Fig. 4          einen schematischen seitlichen Schnitt durch eine erfindungsgemäße Bedieneinrichtung mit Bedien-Feld über unterschiedlich ausgebildeten Sensorelementen.

## Detaillierte Beschreibung der Ausführungsbeispiele

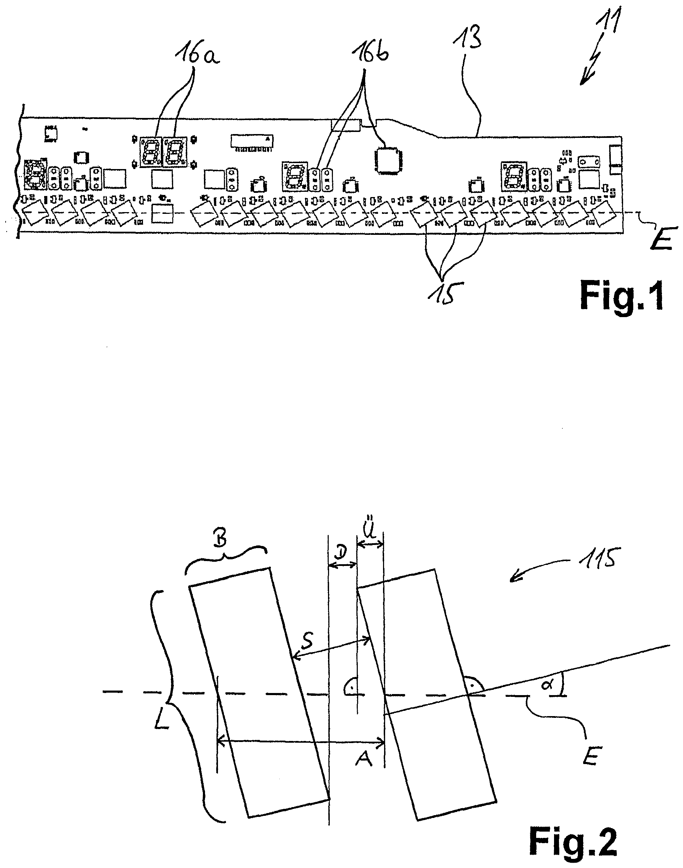

In Fig. 1 ist ein Beispiel für eine erfindungsgemäße Bedieneinrichtung 11 dargestellt. Diese weist eine Leiterplatte 13 auf, auf der eine Vielzahl von kapazitiven Sensorelementen 15 angeordnet ist, und zwar in zwei Gruppen, alle entlang einer Erstreckungs-Linie E, die gestrichelt dargestellt ist. Dabei sind die Sensorelemente 15 relativ nahe beieinander angeordnet und deutlich erkennbar schräg zueinander versetzt bzw. verdreht gegenüber der Linie E, und zwar hier in einem Winkel von etwa 30° jeweils gegen den Uhrzeigersinn verdreht sind. Dies bedeutet, dass die vorgenannten ersten Seiten der Sensorelemente, mit denen sie zueinander hin weisen, einen Winkel von etwa 60° zu der Linie E aufweisen. Dabei ist zu erkennen, dass sich die Sensorelemente 15 in Richtung der Linie E noch nicht überlappen, wenngleich die entsprechenden Ecken der Sensorelemente jeweils nahe beieinander liegen. Aber auch ohne eine solche Überlappung kann der erfindungsgemäße Vorteil der besseren Auswertbarkeit bereits erreicht werden.

Die rechteckigen Sensorelemente 15 sind in Richtung nach schräg rechts oben etwas länger als in der anderen Erstreckungsrichtung nach links oben, und zwar etwa 10%.

Auf der Leiterplatte 13 sind noch weitere Bauteile vorgesehen, und zwar sowohl LED 16a bzw. Sieben-Segment-Anzeigen als auch andere elektrische bzw. elektronische Bauteile 16b.

In Fig. 2 sind in Vergrößerung etwas anders bzw. schmaler und länger ausgebildete Sensorelemente 115 dargestellt, die wiederum um einen Winkel $\alpha$ entgegen dem Uhrzeigersinn gegen eine Erstreckungs-Linie EL verdreht sind, und zwar hier nur um 15°. Des weiteren ist die Breite B eines Sensorelements 115 eingezeichnet sowie die Spaltbreite S, die den Abstand der zueinander weisenden ersten Seiten der Sensorelemente 115 bezeichnet. Mit L ist die Länge und mit B die Breite eines Sensorelements 115 bezeichnet. Mit Ü ist der Überstand bezeichnet, um den die linke obere Ecke des rechten Sensorelements 115 über die Senkrechte übersteht zu dem Schnittpunkt der ersten langen Seite des Sensorelements 115 mit der Linie E. Mit A ist der Abstand der Mittelpunkte der Sensorelemente zueinander bezeichnet bzw. diese entspricht auch dem Abstand, den die Sensorelemente 115 entlang der Linie E zueinander aufweisen.

Eine Differenz D ist das Maß, das sich ergibt, wenn von dem Abstand A die Breite B eines Sensorelements und der zweifache Überstand Ü abgezogen werden. Somit entspricht D dem Abstand der beiden am nächsten zueinander liegenden Punkte der Sensorelemente 115 in Richtung der Linie E.

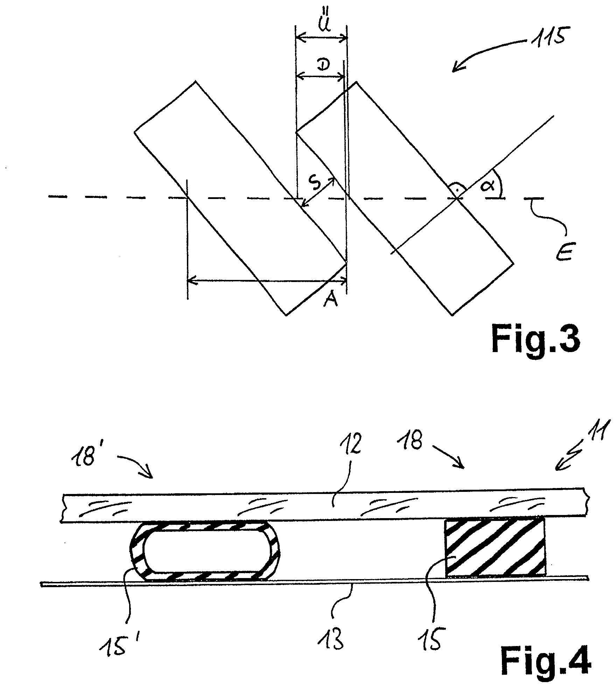

In Fig. 3 ist dargestellt, wie bei gleichem Abstand A und einem Winkel $\alpha$ von etwa 40° das rechte Sensorelement 115 das linke Sensorelement 115 tatsächlich überlappt, und zwar um das Maß D, welches rechnerisch im Vergleich zu demjenigen aus Fig. 2 negativ ist.

Der Wert für S bestimmt sich nach der Formel

$$S = (A-B-(B/2) \times \sin(\alpha) \times \tan(\alpha)) \times \cos(\alpha)$$

Der Überstand Ü berechnet sich nach der Formel

$$Ü = (L/2) \times \sin(\alpha)$$

Der Winkel $\alpha$ ist somit zu bestimmen nach

$$\alpha = \arcsin (2\,Ü/L)$$

In der folgenden Tabelle wird dargestellt, wie sich für ein Sensorelement mit der Breite B = 8 mm für zunehmende Werte für den Überstand Ü der Winkel $\alpha$, die Spaltbreite S und das Maß D. Selbstverständlich ist dies auch noch von dem Wert für den Abstand A abhängig. Bei Fig. 2 überlappen sich die Sensorelemente 115 noch nicht gegenseitig, bei Fig. 3 dagegen erkennbar schon.

| Für B = 8 mm | Ü / mm | $\alpha$ / Grad | S / mm | D / mm |
|---|---|---|---|---|
|  | 0,5 | 7,2 | 1,9 | 1 |
|  | 1 | 14 | 1,7 | 0 |
| Überlappung | 1,5 | 22 | 1,3 | -1 |
| Überlappung | 2 | 30 | 0,7 | -2 |
| Kollision | 3 | 48 | -0,9 | -0,9 |
| Kollision | 4 | 90 | -4 | -4 |

In Fig. 4 ist eine weitere schematische Schnittdarstellung einer erfindungsgemäßen Bedieneinrichtung 11 dargestellt. Unter einem Bedien-Feld 12 der Bedieneinrichtung 11 befindet sich mit etwas Abstand und parallel die Leiterplatte 13. Dargestellt sind hier zwei Sensorelemente 15 und 15' auf der Leiterplatte 13. Das rechte Sensorelement 15 ist im Wesentlichen blockartig ausgebildet, also als massiver Quader und besteht aus elastischem Material, insbesondere elektrisch leitfähigem Kunststoff. Die an die Unterseite des Bedien-Feldes 12 angedrückte Oberseite des Sensorelements 15 bildet an dem entsprechenden Bereich an der Oberseite des Bedien-Feldes 12 einen kapazitiven Berührungsschalter 18, wie dies dem Fachmann bekannt ist. Die andere Ausführung des Sensorelements 15' links in der Fig. 3 weist einen Hohlraum auf und ist somit als Hohlraumabschnitt ausgebildet entsprechend der DE 102 007 008 178 A1. Auch hier definiert die Oberseite des Sensorelements 15' an der Unterseite des Bedien-Feldes 12 an dessen Oberseite einen kapazitiven Berührungsschalter 18'.

**Patentansprüche**

1. Bedieneinrichtung (11) für ein Elektrogerät, mit einem Bedien-Feld, wobei unter dem Bedien-Feld (12) mehrere kapazitive Sensorelemente (15, 15', 115) für einen kapazitiven Berührungs- bzw. Näherungsschalter (18, 18') angeordnet sind, die in einer länglichen, fortlaufenden Linie (E) als Gerade angeordnet sind für eine Bedienung durch Auflegen eines Fingers und Darüberziehen, wobei die Sensorelemente (15, 15', 115) sämtlich gleich ausgebildet sind mit rechteckiger Form mit zwei gegenüberliegenden ersten Seiten und zwei gegenüberliegenden zweiten Seiten, wobei die Sensorelemente mit jeweils einer ihrer ersten Seiten zueinander hin weisend angeordnet sind und mit allen ihren Seiten jeweils parallel zueinander angeordnet sind und somit gleich ausgerichtet sind bezüglich der fortlaufenden Linie (E) als Gerade, wobei die ersten Seiten zu der Linie, entlang derer die Sensorelemente (15, 15', 115) angeordnet sind, um einen Winkel zwischen 15° und 90° verdreht sind, **dadurch gekennzeichnet, dass** die Sensorelemente (15, 15', 115) gebildet sind durch elektrisch leitfähige, elastische Sensorelementkörper, die an die Unterseite des Bedien-Felds (12) angelegt sind.

2. Bedieneinrichtung nach Anspruch 1, **dadurch gekennzeichnet, dass** die Sensorelemente (15, 15', 115) um einen Winkel zwischen 15° und 44° oder zwischen 45° und 80° verdreht sind, vorzugsweise zwischen 46° und 75°.

3. Bedieneinrichtung nach Anspruch 1 oder 2, **dadurch gekennzeichnet, dass** die Sensorelemente (15, 15', 115) eine lange Seite und eine kurze Seite aufweisen, insbesondere mit mindestens 10% Längenunterschied, wobei sie vorzugsweise bis zu doppelt so lang wie breit sind.

4. Bedieneinrichtung nach Anspruch 3, **dadurch gekennzeichnet, dass** die Sensorelemente (15, 15', 115) mit ihren langen Seiten zueinander hin weisen.

5. Bedieneinrichtung nach einem der vorhergehenden Ansprüche, **dadurch gekennzeichnet, dass** sich benachbarte Sensorelemente (15, 15', 115) in der Richtungskomponente der Längserstreckung der Linie (E) als Gerade zumindest ein Stück überlappen, vorzugsweise um mindestens 5% bis 20% ihrer Länge.

6. Bedieneinrichtung nach einem der vorhergehenden Ansprüche, **dadurch gekennzeichnet, dass** die Sensorelementkörper Blockform aufweisen, wobei vorzugsweise die Sensorelementkörper eine Höhe aufweisen, die geringer ist als die Breite und die Länge des Sensorelementkörpers.

**Claims**

1. Operating device (11) for an electrical appliance, having a control panel, wherein a plurality of capacitive sensor elements (15, 15', 115) for a capacitive contact switch or proximity switch (18, 18') are arranged under the control panel (12) and are arranged in an elongated, continuous row (E) as a straight line for operation by application of a finger and drawing the finger over them, wherein the sensor elements (15, 15', 115) all have the same design and have a rectangular shape with two opposite first sides and two opposite second sides, wherein the sensor elements are each arranged with one of their first sides facing one another and are each arranged with all of their sides parallel to one another, and are therefore aligned in the same way with respect to the continuous row (E) as a straight line, wherein the first sides, along which the sensor elements (15, 15', 115) are arranged, are rotated through an angle of between 15° and 90° in relation to the row,
**characterized in that**
the sensor elements (15, 15', 115) are formed by electrically conductive, elastic sensor element bodies which are placed on the underside of the control panel (12).

2. Operating device according to claim 1, **characterized in that** the sensor elements (15, 15', 115) are rotated through an angle of between 15° and 44°, or between 45° and 80°, preferably between 46° and 75°.

3. Operating device according to claim 1 or 2, **characterized in that** the sensor elements (15, 15', 115) have a long side and a short side, in particular with at least 10 % difference in length, wherein preferably they are up to twice as long as they are wide.

4. Operating device according to claim 3, **characterized in that** the long sides of the sensor elements (15, 15', 115) face one another.

5. Operating device according to any of the preceding claims, **characterized in that** adjacent sensor elements (15, 15', 115) overlap at least partially in the direction component of the longitudinal extent of the row (E) as a straight line, preferably by at least 5% to 20% of their length.

6. Operating device according to any of the preceding claims, **characterized in that** the sensor element bodies are in block form, wherein preferably the sensor element bodies have a height which is less than the width and the length of the sensor element body.

**Revendications**

1. Dispositif de commande (11) destiné à un appareil électrique, comportant un panneau de commande, dans lequel, sous le panneau de commande (12), sont disposés plusieurs éléments capteurs capacitifs (15, 15', 115) destinés à un commutateur tactile ou de proximité capacitif (18, 18'), qui sont disposés suivant une ligne longitudinale continue (E) sous forme de droite pour une commande effectuée en appliquant un doigt et en exerçant une traction sur celui-ci, dans lequel les éléments capteurs (15, 15', 115) sont tous réalisés de manière identique avec une forme rectangulaire présentant deux premiers côtés opposés et deux seconds côtés opposés, dans lequel les éléments capteurs sont respectivement disposés de manière à ce que l'un de leurs premiers côtés soit tourné vers l'autre et sont disposés de manière à ce que tous leurs côtés soient respectivement parallèles les uns aux autres et soient par conséquent orientés de la même manière par rapport à la ligne continue (E) sous forme de droite, dans lequel les premiers côtés sont tournés d'un angle compris entre 15° et 90° par rapport à la ligne le long de laquelle sont disposés les éléments capteurs (15, 15', 115), **caractérisé en ce que** les éléments capteurs (15, 15', 115) sont constitués de corps d'éléments capteurs électriquement conducteurs élastiques qui sont appliqués sur la face inférieure du panneau de commande (12) .

2. Dispositif de commande selon la revendication 1, **caractérisé en ce que** les éléments capteurs (15, 15', 115) sont tournés d'un angle compris entre 15° et 44°, ou compris entre 45° et 80°, de préférence, compris entre 46° et 75°.

3. Dispositif de commande selon la revendication 1 ou 2, **caractérisé en ce que** les éléments capteurs (15, 15', 115) présentent un côté long et un côté court, ayant notamment une différence de longueur d'au moins 10 %, dans lequel leur longueur peut de préférence atteindre le double de leur largeur.

4. Dispositif de commande selon la revendication 3, **caractérisé en ce que** les éléments capteurs (15, 15', 115) ont leurs côtés longs tournés les uns vers les autres.

5. Dispositif de commande selon l'une des revendications précédentes, **caractérisé en ce que** des éléments capteurs voisins (15, 15', 115) se chevauchent au moins partiellement suivant la composante de direction de l'extension longitudinale de la ligne (E) sous forme de droite, et de préférence d'au moins 5 % à 20 % de leur longueur.

6. Dispositif de commande selon l'une des revendications précédentes, **caractérisé en ce que** les corps d'éléments capteurs présentent une forme de bloc, dans lequel les corps d'éléments capteurs présentent de préférence une hauteur qui est inférieure à la largeur et à la longueur du corps d'élément capteur.

**Fig.1**

**Fig.2**

**Fig.3**

**Fig.4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008033369 A
- WO 2007036247 A
- US 20070262962 A1
- EP 1416636 A2
- EP 859467 A
- EP 859468 A
- DE 102007008178 A1